# EUROPEAN PATENT APPLICATION

(11) **EP 4 822 679 A1**
(43) Date of publication of application: **14.10.2026**
(21) Application number: 24901109.9
(22) Date of filing: 05.12.2024
(51) Int. Cl.: G09G 3/20

(54) **SLEW BOOST CIRCUIT AND METHOD FOR CONTROLLING SLEW BOOST CIRCUIT**

(30) Priority: 05.12.2023 KR 20230174146
(71) Applicant: LX Semicon Co., Ltd., Daejeon 34027 (KR)
(72) Inventor: YU, Sang Duk, Daejeon 34027 (KR); YEO, Sung Dae, Daejeon 34027 (KR); KIM, Won Youn, Daejeon 34027 (KR)
(74) Representative: Ter Meer und Partner mbB
(86) International application number: PCT/KR2024/019891
(87) International publication number: WO 2025/121923

(57) **Abstract**

The present disclosure relates to a slew boost circuit including a comparator that compares a first differential input voltage and a second differential input voltage and generates a dynamic current, a first boosting current supply which, when the dynamic current is generated, mirrors the generated dynamic current and supplies same to a main source amplifier circuit, and a second boosting current supply which supplies additional dynamic current to the main source amplifier circuit on the basis of the operation of a timing controller.

## Description

### [Technical Field]

The present disclosure relates to a slew boost circuit and a method for controlling the slew boost circuit.

### [Background Art]

In general, display panels, particularly OLED displays require high resolution and high response speeds. To achieve this, display driver ICs accurately process input signals and transmit the same as output signals to display panels. In this process, rise and fall speeds of an output signal, i.e., the slew rate, have a significant impact on display performance.

In existing technologies, various circuit designs have been proposed to detect and correct the difference between input and output signals in order to reduce slew rate deviations. However, such technologies suffer from a problem that the signal detection capability deteriorates when the rate of change of the input signal is low, that is, in a low slew rate situation, resulting in insufficient correction effects by a slew boost circuit. In particular, when an output signal transmission distance is long and the load is high, such as in an edge channel of a display, the rise and fall speeds of the signal decrease, which can lead to output quality degradation.

Therefore, the development of a slew boost circuit capable of solving such a problem is required.

### [Disclosure]

### [Technical Problem]

Therefore, the present disclosure has been made in view of the above problems, and it is an aspect of the present disclosure to provide a new circuit and control method for correcting slew rate deviations occurring in each channel of a display driver IC. In particular, an aspect of the present disclosure is to effectively correct a low slew rate signal occurring in an edge channel to shorten a settling time and improve the quality of display output.

The technical aspects to be achieved by the present disclosure are not limited to those mentioned above, and other unmentioned technical aspects will be clearly understood by those skilled in the art from the description below.

### [Technical Solution]

In accordance with an aspect of the present disclosure, the above and other objects can be accomplished by the provision of a slew boost circuit for supplying a current to a main source amplifier circuit, including a comparator configured to compare a first differential input voltage and a second differential input voltage and to generate a current, a first boosting current supply configured to mirror the generated current when the current is generated and to supply the current to the main source amplifier circuit, and a second boosting current supply configured to additionally supply a current to the main source amplifier circuit based on an operation of a timing controller.

In at least one embodiment of the present disclosure, the comparator may include first and second comparison transistors having gates to which the first differential input voltage is applied and sources to which the second differential input voltage is applied, wherein when the first differential input voltage rises, a current may flow through the first comparison transistor, and when the first differential input voltage falls, a current may flow through the second comparison transistor.

In at least one embodiment of the present disclosure, the first boosting current supply may include a mirror circuit configured to generate a mirroring current by mirroring current flowing through the first and second comparison transistors, and supply the mirroring current to a common source and/or a common gate of the main source amplifier circuit.

In at least one embodiment of the present disclosure, the timing controller may be synchronized with a timing of fluctuation in the first differential input voltage and set a current supply time of the second boosting current supply differently for each channel position of the display driver IC.

In at least one embodiment of the present disclosure, the second boosting current supply may include first and second current source transistors, and the timing controller may apply a bias to gate nodes of the first and second current source transistors to adjust an amount of current supplied to the common source of the main source amplifier circuit.

In at least one embodiment of the present disclosure, the current supply time may be set within the range of 50 ns to 500 ns.

In at least one embodiment of the present disclosure, a toggle circuit in which an N-type transistor and a P-type transistor are connected in parallel may be disposed between a terminal to which the first differential input voltage is input and gates of the first and second comparison transistors.

In accordance with another aspect of the present disclosure, there is provided a method for controlling a slew boost circuit for supplying dynamic current to a main source amplifier circuit, including comparing a first differential input voltage and a second differential input voltage and generating a current, mirroring the generated current when the current is generated and supplying the current to the main source amplifier circuit, and additionally supplying a current to the main source amplifier circuit based on an operation of a timing controller.

In at least one embodiment of the present disclosure, the generating a current may include allowing a current to flow to the first comparison transistor when the first differential input voltage rises, and allowing a current to flow to the second comparison transistor when the first differential input voltage falls.

In at least one embodiment of the present disclosure, the mirroring the generated current and supplying the current to the main source amplifier circuit may include supplying the mirrored current to a common source and/or a common gate of the main source amplifier circuit.

In at least one embodiment of the present disclosure, the timing controller may be synchronized at a timing of fluctuation in the first differential input voltage and may set a current supply time of the second boosting current supply differently for each channel position of a display driver IC.

In at least one embodiment of the present disclosure, the current supply time may be set within the range of 50 ns to 500 ns.

### [Advantageous effects]

According to at least one embodiment of the present disclosure, a slew rate deviation between a center channel and an edge channel of a display driver IC can be effectively corrected. Accordingly, by maintaining uniform signal quality in both the center and edge channels of the display driver IC, the overall signal transmission characteristics of the display can be improved.

The effects obtained from the present disclosure are not limited to those mentioned above, and other unmentioned effects will be clearly understood by those skilled in the art from the description below.

### [Description of Drawings]

FIG. 1 is a diagram showing a display device configuration according to an embodiment of the present disclosure.
FIG. 2 is a diagram showing a data driving device configuration according to an embodiment of the present disclosure.
FIG. 3 is a block diagram of a differential amplifier according to an embodiment of the present disclosure.
FIG. 4 is a diagram showing a main source amplifier circuit configuration according to an embodiment of the present disclosure.
FIG. 5 is a diagram showing a slew boost circuit according to an embodiment of the present disclosure.
FIG. 6 is a diagram illustrating the effects of the slew boost circuit according to an embodiment of the present disclosure.

### [Best Mode]

The present disclosure can be modified in various manners, and specific embodiments are illustrated and described in the drawings. However, this is not intended to limit the present disclosure to specific embodiments, but rather to encompass all modifications, equivalents, and alternatives falling within the spirit and scope of the present disclosure.

The suffixes "module" and "unit" used herein are used solely for nominal distinction between components and should not be construed as implying that the components are physically or chemically distinct or separated, or capable of being so distinguished or separated.

Terms containing ordinal numbers, such as "first" and "second", may be used to describe various components, but these components are not limited by these terms. These terms may be used solely as nominal terms to distinguish one component from another, and their relative ordering is determined not by the name itself, but by the context of the description.

The term "and/or" is used to encompass any combination of multiple items the term refers to. For example, "A and/or B" means all three cases of "A", "B", "A and B".

When a component is referred to as being "coupled" or "connected" to another component, it should be understood that the component may be directly coupled or connected to the other component, but that other components may also be present therebetween.

The terms used in this application are used solely to describe specific embodiments and are not intended to limit the present disclosure. Singular expressions encompass plural expressions unless the context clearly dictates otherwise. In this application, the term "comprise" or "have" is intended to indicate the presence of a feature, a number, a step, an operation, a component, a part, or a combination thereof described in the specification, but does not preclude the presence or addition of one or more other features, numbers, steps, operations, components, parts, or combinations thereof.

Unless otherwise defined, all terms, including technical or scientific terms, used herein have the same meaning as commonly understood by one of ordinary skill in the art to which the present disclosure pertains. Terms defined in commonly used dictionaries should be interpreted as having meanings consistent with their meanings in the context of the relevant technology and, unless explicitly defined herein, should not be interpreted in an idealized or overly formal sense.

Furthermore, the term "unit", "control unit", "control device", or "controller" is merely a term commonly used to designate a device that controls a given function and does not imply a generic functional unit. For example, a device designated by this term may include a communication device that communicates with other controllers or sensors to control the corresponding function, a computer-readable recording medium that stores an operating system, logic instructions, and input/output information, and one or more processors that perform determination, calculation, and decision necessary to control the corresponding function.

Meanwhile, a processor may include semiconductor integrated circuits and/or electronic components that perform one or more of comparison, determination, calculation, and decision to achieve a programmed function. For example, the processor may be any one or a combination of a computer, a microprocessor, a CPU, an ASIC, electronic circuitry, and logic circuits.

The processor may be electrically connected to a memory and may read/write data from/to the memory. The memory and the processor may be integrated or physically separate.

Hereinafter, embodiments of the present disclosure will be described in detail with reference to the accompanying drawings.

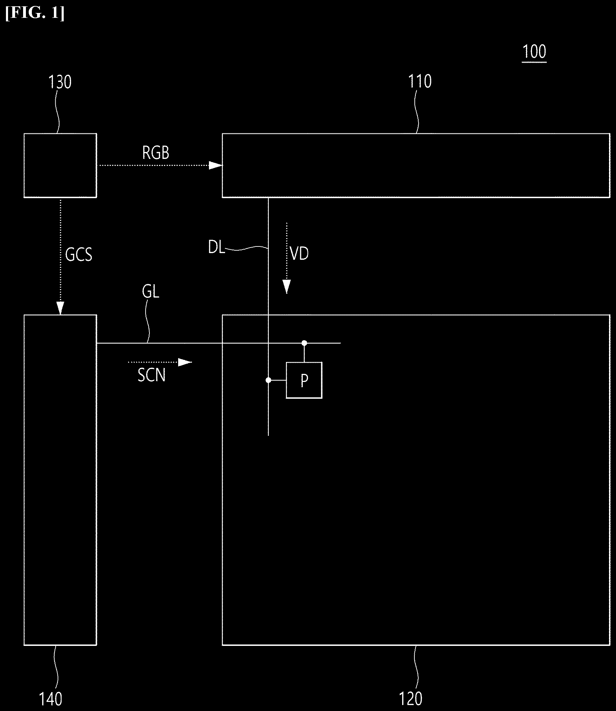

FIG. 1 is a diagram showing a display device configuration according to an embodiment of the present disclosure.

Referring to FIG. 1, the display device 100 may include a display panel 120, a data processing device 130, a gate driving device 140, and a data driving device 110.

The display panel 120 may be a liquid crystal display (LCD) panel or a self-emissive element panel such as an organic light emitting diode (OLED) panel.

When the display panel 120 is an LCD panel, the display panel 120 may include a backlight, a liquid crystal, and a common electrode, and a pixel electrode and a driving transistor may be disposed at each pixel. When a scan signal is supplied to a gate of the driving transistor, the driving transistor is turned on, and a data voltage can be supplied to the pixel electrode. Then, an electric field is formed between the pixel electrode and the common electrode according to the data voltage, changing the liquid crystal alignment direction, and accordingly, the degree of transmission of light supplied from the backlight changes, thereby allowing the brightness of pixels to be controlled.

In the display panel 120, a plurality of data lines DL and a plurality of gate lines GL may be disposed in a matrix form. Each data line DL may be connected to the source of the driving transistor of each pixel, and each gate line GL may be connected to the gate terminal of the driving transistor of each pixel. When a scan signal SCN is supplied to the gate line GL, the driving transistor is turned on, and a data voltage VD supplied through the data line DL can be transmitted to the pixel electrode.

A parasitic capacitor may be formed in the data line DL. The parasitic capacitor may be formed between the data line DL and the common electrode, or between the data line DL and the pixel electrode. From the perspective of the data driving device 110 that supplies the data voltage VD, the parasitic capacitor may be recognized as a load. The data driving device 110 needs to supply power to the data line DL in proportion to the capacitance of the parasitic capacitor.

The display panel 120 may be a self-emissive element panel such as an OLED panel. In addition to OLED panels, other types of self-emissive element panels, such as micro-LED panels, may be used.

A scan transistor, a driving transistor, and an OLED may be disposed in each pixel of the OLED panel. When a scan signal SCN is supplied to the gate of the scan transistor, the scan transistor is turned on, and a data voltage VD can be supplied to the driving transistor through the scan transistor. In the OLED panel, the data voltage VD may be supplied to the gate of the driving transistor. The magnitude of the conduction current of the driving transistor is determined according to the magnitude of the data voltage VD, and the brightness of the OLED connected to the driving transistor may be controlled according to the magnitude of the conduction current of the driving transistor.

In the display panel 120, a plurality of data lines DL and a plurality of gate lines GL may be disposed in a matrix form. Each data line DL may be connected to the source terminal of the scan transistor of each subpixel, and each gate line GL may be connected to the gate terminal of the source transistor of each subpixel. When a scan signal SCN is supplied to the gate line GL, the scan transistor is turned on, allowing the data voltage VD supplied through the data line DL to be transmitted to the driving transistor.

A parasitic capacitor may be formed in the data line DL. The parasitic capacitor may be formed between the data line DL and the cathode of the OLED, or between the data line DL and the anode of the OLED. From the perspective of the data driving device 110 that supplies the data voltage VD, the parasitic capacitor may be recognized as a load. The larger the capacitance of the parasitic capacitor, the more power the data driving device 110 needs to supply to the data line.

The data processing device 130 may receive image data from an external device, for example, a device called a host or an application processor (AP). Then, the image data in the format of the external device may be converted into image data RGB in a format that can be processed by the data driving device 110. Then, the data processing device 130 may transmit the converted image data RGB to the data driving device 110.

The image data RGB may include pixel data representing intensity value for each pixel P. Pixel data for a single pixel P may, for example, includes 8 bits of data per subpixel, representing color channel values from 0 to 255. The data processing device 130 may generate pixel data for each pixel, include the pixel data in image data RGB, and transmit the image data RGB to the data driving device 110.

The data processing device 130 may transmit control signals to devices involved in driving the display panel, such as the data driving device 110 and the gate driving device 140. The data processing device 130 may transmit a data control signal DCS to the data driving device 110 and transmit a gate control signal GCS to the gate driving device 140.

The control signals DCS and GCS may include setting information for each device. For example, the data processing device 130 may receive setting information from an external device, verify the setting information for each device, include the setting information in the corresponding control signal DCS or GCS, and transmit the same.

The control signals DCS and GCS may include timing signals for controlling each device. The timing signals may be, for example, a vertical synchronization signal Vsync and a horizontal synchronization signal Hsync. The data driving device 110 or the gate driving device 140 may distinguish frames according to the timing signals and distinguish each horizontal time. In terms of controlling the timing of each device, the data processing device 130 is also referred to as a timing controller.

The gate driving device 140 may supply a scan signal SCN to pixels P disposed in the display panel 120. Then, pixels to which a scan signal SCN for instructing the pixels to be turned on has been supplied are selected, and a data voltage VD may be supplied to the selected pixels.

The gate driving device 140 may supply a scan signal SCN through a gate line GL. A plurality of gate lines GL may be disposed on the display panel 120. Each gate line GL may be connected to pixels P disposed in a line in one direction, e.g., horizontal direction. The gate driving device 140 may supply a scan signal SCN indicating turn-on to one of the gate lines GL, and pixels P connected to the gate line GL can be selected. The gate driving device 140 may supply the scan signal SCN indicating turn-on while changing gate lines GL at every horizontal time.

The data driving device 110 may drive the pixels P disposed in the display panel 120.

The data driving device 110 may receive image data RGB from the data processing device 130. The data driving device 110 may check pixel data for each pixel P included in the image data RGB, generate a data voltage VD corresponding to the pixel data, and supply the data voltage VD to each pixel P.

Pixel data can represent a grayscale value for each pixel P, and the data driving device 110 can generate a data voltage VD corresponding to this grayscale value.

Pixel data may be stored in a latch circuit of the data driving device 110 and then output in the form of a digital signal. Additionally, the data driving device 110 may convert the digital signal into an analog voltage using gamma reference voltages.

There is a difference between a grayscale corresponding to physical brightness and a grayscale corresponding to brightness perceived by humans. Correcting this difference is called gamma conversion. When the data driving device 110 converts a digital signal into an analog voltage, the data driving device 110 may also apply gamma conversion simultaneously. For example, the data driving device 110 can apply digital-to-analog conversion and gamma conversion simultaneously by using voltages used for digital-to-analog conversion as voltages to which gamma conversion has been applied, that is, gamma reference voltages.

An analog voltage may not be suitable for driving pixels P because the power level thereof is low. Therefore, the data driving device 110 may amplify the analog voltage to generate a data voltage VD and supply the data voltage VD, which has a relatively high power level, to the pixels P.

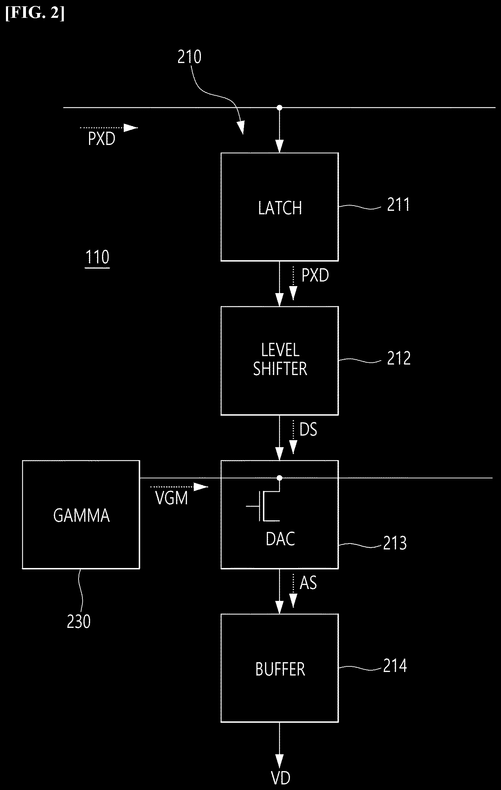

FIG. 2 is a diagram showing a data driving device configuration according to an embodiment of the present disclosure.

Referring to FIG. 2, the data driving device 110 may include a channel circuit 210 and a gamma reference voltage generation circuit 230.

The channel circuit 210 may include a latch circuit 211, a level shifter 212, a digital-to-analog converter (DAC) 213, and a buffer circuit 214 and may receive pixel data PXD corresponding to a grayscale value of a pixel to generate a data voltage VD and supply the data voltage VD to a data line connected to the pixel.

The latch circuit 211 sequentially stores pixel data PXD received through a data bus line.

The latch circuit 211 may have two latches internally. The first latch stores pixel data to be output at the next horizontal time, and the second latch stores pixel data to be output at the current horizontal time. When the next horizontal time arrives, pixel data to be output at the next horizontal time is stored in the first latch, and the pixel data stored in the first latch is moved to and stored in the second latch.

The output timing of the latch circuit 211 may be determined according to a latch output signal generated at each horizontal time. The latch output signal may be synchronized with the horizontal synchronization signal. Alternatively, the latch output signal may be a signal having a different phase from the horizontal synchronization signal and the same period as the horizontal synchronization signal.

The latch circuit 211 transfers pixel data PXD stored in the latch circuit 211 to the level shifter 212 according to the latch output signal.

The level shifter 212 converts the pixel data PXD into a digital signal DS. The level shifter 212 may increase the signal level while converting the pixel data PXD into a digital signal DS.

The pixel data PXD may be a signal with a low voltage or power level. The level shifter 212 converts the pixel data PXD into a digital signal DS with a high voltage or power level.

Pixel data can represent a grayscale value for each pixel P, and the data driving device 110 can generate a data voltage VD corresponding to this grayscale value.

The DAC 213 receives the digital signal DS and drive gates of internal switches. The DAC 213 converts the digital signal DS into an analog voltage AS by driving the gates of the switches.

The DAC 213 may include a plurality of switches. The switches may selectively connect one of a plurality of gamma reference voltage lines through which a plurality of gamma reference voltages is supplied to the output depending on the on/off state. The voltage applied to the selected gamma reference voltage line may become the analog voltage AS. The digital signal DS can change the on/off states of the switches by being supplied to the gates of the switches.

The digital signal DS may be supplied to drive the gates of the switches. The digital signal DS is output by the level shifter 212, and in this regard, gate loads of the switches may become part of an output load of the level shifter 212. The data driving device 110 may include the gamma reference voltage generation circuit 230 that supplies gamma reference voltages VGM to the DAC 213.

The channel circuit 210 may include a buffer circuit 214 positioned between the output of the DAC 213 and the pixels.

The buffer circuit 214 may amplify the output of the DAC 213 and supply the same to a data line connected to a pixel. The buffer circuit 214 may amplify the analog voltage AS to generate a data voltage VD and supply the data voltage VD to the data line.

The buffer circuit 214 may include a differential amplifier for amplifying the analog voltage AS into the data voltage VD.

The differential amplifier may be a Rail-to-Rail Class-A type amplifier. The buffer circuit 214 may generate the data voltage VD by amplifying the analog voltage AS using this differential amplifier.

The input and output of the differential amplifier may be connected in a buffer structure. For example, the output terminal of the differential amplifier can be connected to the negative input terminal of the differential amplifier. Additionally, the analog voltage AS can be supplied to the positive input terminal of the differential amplifier.

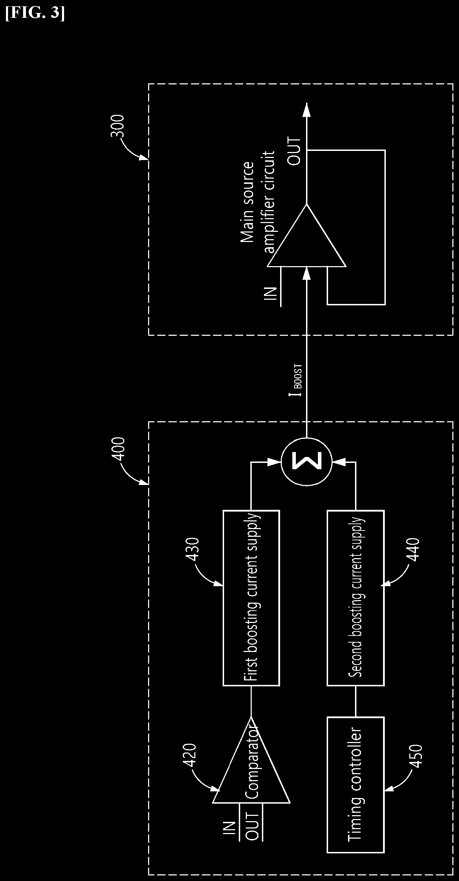

FIG. 3 is a block diagram of a differential amplifier according to an embodiment of the present disclosure.

Referring to FIG. 3, the differential amplifier may include a main source amplifier circuit 300 and a boosting circuit 400.

The boosting circuit 400 may include a comparator 420, a first boosting current supply 430, a second boosting current supply 440, and a timing controller 450.

The comparator 420 may receive the analog voltage AS, which is the output voltage of the DAC, as an input signal, receive an output value, which is a voltage generated by amplification, as another input signal, and compare the voltage levels of the two signals. If there is a voltage level difference between the two signals, current flows to the first boosting current supply 430, and this current can be mirrored in first and second mirror circuits of the first boosting current supply 430 and supplied to the main source amplification circuit 300.

The second boosting current supply 440 is connected in parallel with the first boosting current supply 430 and can supply current to the main source amplifier circuit 300 based on the operation of the timing controller 450.

The timing controller 450 may control the operating time of the second boosting current supply 440 by synchronizing with a timing of change in an input signal. Additionally, the operating time may be set depending on each channel position of the display driver IC.

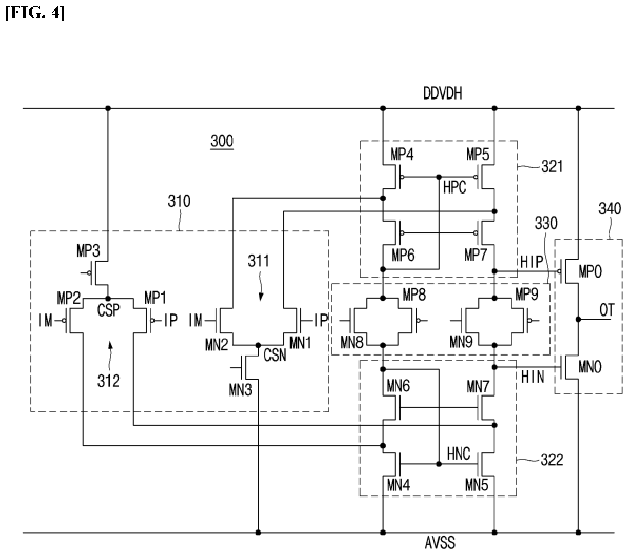

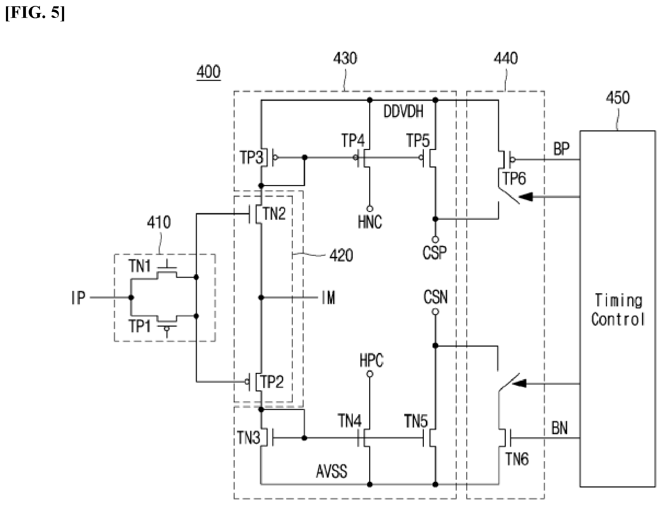

Details regarding the main source amplifier circuit 300 and the boosting circuit 400 will be described with reference to FIG. 4 and FIG. 5.

FIG. 4 is a diagram showing the configuration of the main source amplifier circuit according to an embodiment of the present disclosure.

Referring to FIG. 4, the main source amplifier circuit 300 may include a first circuit part 310, a second circuit part 321, a third circuit part 322, a fourth circuit part 330, and a fifth circuit part 340.

The first circuit part 310 is a circuit that generates differential currents according to differential input voltages and may be referred to as an input circuit. Hereinafter, the first circuit part 310 will be referred to as the input circuit 310 in the embodiment.

The second circuit part 321 controls a gate voltage of a first output transistor MPO according to first differential currents generated in the input circuit 310, and the third circuit part 322 controls a gate voltage of a second output transistor MNO according to second differential currents generated in the input circuit 310. Since the second circuit part 321 and the third circuit part 322 take the form of a current mirror circuit, the two circuits may be collectively referred to as a current mirror circuit 321 and 322, the second circuit part 321 may be referred to as a first current mirror circuit, and the third circuit part 322 may be referred to as a second current mirror circuit. In the following embodiment, the second circuit part 321 is referred to as the first current mirror circuit 321, and the third circuit part 322 is referred to as the second current mirror circuit.

The fourth circuit part 330 is a circuit that provides a bias current and may be referred to as a bias circuit. In the following description, the fourth circuit part 330 will be referred to as a bias circuit 330.

The fifth circuit part 340 may include the first output transistor MPO disposed between a first voltage rail DDVDH and an output terminal OT, and the second output transistor MNO disposed between a second voltage rail AVSS and the output terminal OT. The fifth circuit part 340 includes the output terminal OT and may be referred to as an output circuit. In the following description, the fifth circuit part 340 will be referred to as an output circuit 340.

In the main source amplifier circuit 300, the input circuit 310, the current mirror circuit 321 and 322, the bias circuit 330, and the output circuit 340 can constitute a rail-to-rail class-A amplifier.

The main source amplifier circuit 300 may include a first voltage rail through which a high driving voltage DDVDH is supplied and a second voltage rail through which a low driving voltage AVSS is supplied. Additionally, one side of the input circuit 310, the current mirror circuit 321 and 322, and the output circuit 340 may be connected to the first voltage rail and the other side may be connected to the second voltage rail.

The main source amplifier circuit 300 may receive differential input voltages IP and IM and supply an output voltage OT to the outside. In the main source amplifier circuit 300, the first differential input voltage IP may be input through a first input terminal, and the second differential input voltage IM may be input through a second input terminal. In addition, the output voltage OT may be supplied to the outside through an output terminal of the main source amplifier circuit 300. For convenience of explanation, the reference symbol IP may be used to refer to the first differential input voltage and may also be used to refer to the first input terminal. Further, the reference symbol IM may be used to refer to the second differential input voltage and may also be used to refer to the second input terminal. Further, the reference symbol OT may be used to refer to the output voltage and may also be used to refer to the output terminal. The first differential input voltage IP may be referred to as a positive input voltage, and the first input terminal may be referred to as a positive input terminal. The second differential input voltage IM may be referred to as a negative input voltage, and the second input terminal may be referred to as a negative input terminal.

When the main source amplifier circuit 300 serves as a buffer, the negative input terminal can be connected to the output terminal. The output voltage OT can follow the waveform of the first differential input voltage IP.

The rate at which the output voltage OT follows the waveform of the first differential input voltage IP may vary depending on the slew rate of the main source amplifier circuit 300, and the main source amplifier circuit 300 according to an embodiment can improve the slew rate of the main source amplifier circuit 300 by additionally supplying dynamic current through the boosting circuit 400. Dynamic current may occur in response to fluctuations in differential input voltages (particularly, the first differential input voltage IP). For example, dynamic current may occur when the first differential input voltage IP has a rising waveform or a falling waveform. Dynamic current may not occur when the differential input voltages (particularly, the first differential input voltage IP) are in a static state. For example, dynamic current may not occur when the first differential input voltage IP maintains a constant level. According to this structure, the main source amplifier circuit 300 can improve the slew rate without consuming additional static power.

The output circuit 340 may include the first output transistor MPO disposed between the first voltage rail and the output terminal, and the second output transistor MNO disposed between the second voltage rail and the output terminal, and the slew rate of the main source amplifier circuit 300 may be significantly affected by the magnitude of the current that charges and discharges the gates of the first output transistor MPO and the second output transistor MNO. For example, when the gate voltage is increased or decreased to control the magnitude of the current flowing to the first output transistor MPO and the second output transistor MNO in response to the dynamic waveform of the first differential input voltage IP, if the current that charges and discharges the gates is large, the fluctuation of the current flowing to the first output transistor MPO and the second output transistor MNO increases, and thus the slew rate can be improved.

The main source amplifier circuit 300 according to an embodiment may have a structure in which dynamic current is additionally supplied in response to fluctuations in differential input voltages and such dynamic current increases the current that charges and discharges the gates of the first output transistor MPO and the second output transistor MNO.

The current that charges and discharges the first output transistor MPO and the second output transistor MNO may be affected by the current of the input circuit 310 and the current of the current mirror circuit 321 and 322. The main source amplifier circuit 300 may increase the current that that charges and discharges the first output transistor MPO and the second output transistor MNO by additionally supplying dynamic current to the input circuit 310 and/or the current mirror circuit 321 and 322.

The input circuit 310 may include a first differential amplifier circuit 311 and a second differential amplifier circuit 312.

The first differential amplifier circuit 311 may include a first N-type transistor MN1 and a second N-type transistor MN2 having a common source structure. The source of the first N-type transistor MN1 and the second N-type transistor MN2 may be connected to the second voltage rail through which the low driving voltage AVSS is supplied through a third N-type transistor MN3.

A bias voltage may be supplied to the gate of the third N-type transistor MN3, and according to this bias voltage, the third N-type transistor MN3 can serve as a bias current source.

The first differential input voltage IP may be supplied to the gate of the first N-type transistor MN1, and the second differential input voltage IM may be supplied to the gate of the second N-type transistor MN2.

When the first differential input voltage IP increases, more current may flow through the first N-type transistor MN1. When more current flows through the first N-type transistor MN1, more current flows through the first output transistor MPO and less current flows through the second output transistor MNO, causing the output voltage OT to increase. When the first input voltage IP decreases, less current may flow through the first N-type transistor MN1. When less current flows through the first N-type transistor MN1, less current flows through the first output transistor MPO and more current flows through the second output transistor MNO, causing the output voltage OT to decrease.

The second differential amplifier circuit 312 may include a first P-type transistor MP1 and a second P-type transistor MP2 having a common source structure. The source of the first P-type transistor MP1 and the second P-type transistor MP2 may be connected to the first voltage rail through which the high driving voltage DDVDH is supplied through a third P-type transistor MP3.

A bias voltage may be supplied to the gate of the third P-type transistor MP3, and according to the bias voltage, the third P-type transistor MP3 can serve as a bias current source.

The first differential input voltage IP may be supplied to the gate of the first P-type transistor MP1, and the second differential input voltage IM may be supplied to the gate of the second P-type transistor MP2.

When the first differential input voltage IP increases, less current may flow through the first P-type transistor MP1. When less current flows through the first P-type transistor MP1, more current flows through the first output transistor MPO and less current flows through the second output transistor MNO, causing the output voltage OT to increase. When the first input voltage IP decreases, more current may flow through the first P-type transistor MP1. When more current flows through the first P-type transistor MP1, less current flows through the first output transistor MPO and more current flows through the second output transistor MNO, causing the output voltage OT to decrease.

The current mirror circuit 321 and 322 may include a first current mirror circuit 321 and a second current mirror circuit 322.

The first current mirror circuit 321 may include a first reference current transistor MP4 and a first mirroring current transistor MP5.

The first current mirror circuit 321 may have a common gate structure. The gate of the first reference current transistor MP4 may be connected to the gate of the first mirroring current transistor MP5.

One side of the first current mirror circuit 321 may be connected to the first voltage rail through which the high driving voltage DDVDH is supplied. The source of the first reference current transistor MP4 and the source of the first mirroring current transistor MP5 may be connected to the first voltage rail.

A first reference current may flow through the first reference current transistor MP4, and a mirroring current for the first reference current may flow through the first mirroring current transistor MP5.

A first additional transistor circuit having a common gate structure may be connected to the drain of the first reference current transistor MP4 and the drain of the first mirroring current transistor MP5.

The first additional transistor circuit may include a first additional transistor MP6 connected to the drain of the first reference current transistor MP4 and a second additional transistor MP7 connected to the drain of the first mirroring current transistor MP5. The first additional transistor MP6 may perform additional functions such as limiting the amount of current flowing to the first reference current transistor MP4, and the second additional transistor MP7 may perform additional functions such as limiting the amount of current flowing to the first mirroring current transistor MP5.

To constitute a current mirror circuit, the gate and drain of the first reference current transistor MP4 may be electrically connected. In a normal operation, since the first additional transistor MP6 and the second additional transistor MP7 can operate as bypass circuits, the gate of the first reference current transistor MP4 and the drain of the first additional transistor MP6 can be connected.

In the first differential amplifier circuit 311 of the input circuit 310, the drain of the first N-type transistor MN1 can be connected to the drain of the first mirroring current transistor MP5. Further, in the first differential amplifier circuit 311, the drain of the second N-type transistor MN2 can be connected to the drain of the first reference current transistor MP4.

The second current mirror circuit 322 may include a second reference current transistor MN4 and a second mirroring current transistor MN5. The second current mirror circuit 322 may have a common gate structure. The gate of the second reference current transistor MN4 can be connected to the gate of the second mirroring current transistor MN5.

One side of the second current mirror circuit 322 may be connected to the second voltage rail through which the low driving voltage AVSS is supplied. The source of the second reference current transistor MN4 and the source of the second mirroring current transistor MN5 may be connected to the second voltage rail.

A second reference current may flow through the second reference current transistor MN4, and a mirroring current for the second reference current may flow through the second mirroring current transistor MN5.

A second additional transistor circuit having a common gate structure may be connected to the drain of the second reference current transistor MN4 and the drain of the second mirroring current transistor MN5.

The second additional transistor circuit may include a third additional transistor MN6 connected to the drain of the second reference current transistor MN4 and a fourth additional transistor MN7 connected to the drain of the second mirroring current transistor MN5. The third additional transistor MN6 may perform additional functions such as limiting the amount of current flowing to the second reference current transistor MN4, and the fourth additional transistor MN7 may perform additional functions such as limiting the amount of current flowing to the second mirroring current transistor MN5.

To constitute a current mirror circuit, the gate and drain of the second reference current transistor MN4 can be electrically connected. In a normal operation, since the third additional transistor MN6 and the fourth additional transistor MN7 can operate as bypass circuits, the gate of the second reference current transistor MN4 and the drain of the third additional transistor MN6 can be connected.

In the second differential amplifier circuit 312 of the input circuit 310, the drain of the first P-type transistor MP1 may be connected to the drain of the second mirroring current transistor MN5. In addition, the drain of the second P-type transistor MP2 in the second differential amplifier circuit 312 may be connected to the drain of the second reference current transistor MN4.

The bias circuit 330 may be disposed between the first current mirror circuit 321 and the second current mirror circuit 322.

The bias circuit 330 may include a first bias circuit and a second bias circuit.

The first bias circuit may have a structure in which one N-type transistor MN8 and one P-type transistor MP8 are connected in parallel. A bias current supplied by the first bias circuit may be determined according to a bias voltage supplied to the gates of the N-type transistor MN8 and the P-type transistor MP8.

The second bias circuit may have a structure in which another N-type transistor MN9 and another P-type transistor MP9 are connected in parallel. A bias current supplied by the second bias circuit may be determined according to a bias voltage supplied to the gates of the N-type transistor MN9 and the P-type transistor MP9.

The first bias circuit may form a current path by being electrically connected to the first reference current transistor MP4 of the first current mirror circuit 321 and the second reference current transistor MN4 of the second current mirror circuit 322. This path may be called a reference current path. Through the reference current path, the first bias current generated by the first bias circuit can flow to the second voltage rail through the first voltage rail, the first reference current transistor MP4, the first bias circuit, and the second reference current transistor MN4.

The second bias circuit may form another current path by being electrically connected to the first mirroring current transistor MP5 of the first current mirror circuit 321 and the second mirroring current transistor MN5 of the second current mirror circuit 322. This path may be called a mirroring current path. Through the mirroring current path, the second bias current generated by the second bias circuit can flow to the second voltage rail through the first voltage rail, the first mirroring current transistor MP5, the second bias circuit, and the second mirroring current transistor MN5.

In the output circuit 340, the source of the first output transistor MPO may be connected to the first voltage rail and the drain thereof may be connected to the output terminal OT. Additionally, the gate of the first output transistor MPO may be connected to the contact node of the second bias circuit and the first current mirror circuit 321 on the mirroring current path.

In the output circuit 340, the source of the second output transistor MNO may be connected to the second voltage rail and the drain thereof may be connected to the output terminal OT. Additionally, the gate of the second output transistor MNO may be connected to the contact node of the second bias circuit and the second current mirror circuit 322 on the mirroring current path.

The input circuit 310 may generate differential currents according to the differential input voltages IP and IM. In addition, the current mirror circuit 321 and 322 may control the gate voltages of the first output transistor MPO and the second output transistor MNO according to the differential currents. In addition, the boosting circuit 400 can improve the slew rate of the main source amplifier circuit 300 by supplying additional dynamic current to the input circuit 310 or supplying additional dynamic current to the current mirror circuit 321 and 322 in response to fluctuations in the differential input voltages IP and IM.

The boosting circuit 400 may supply dynamic current to the input circuit 310. The input circuit 310 may include differential amplifier circuits having a common source structure in which the differential input voltages IP and IM are input to gates, and the boosting circuit 400 may supply dynamic current to the common sources of these differential amplifier circuits. For example, the boosting circuit 400 may supply dynamic current to the common source CSN of the first differential amplifier circuit 311 or to the common source CSP of the second differential amplifier circuit 312.

The boosting circuit 400 may supply dynamic current to the current mirror circuit 321 and 322. The current mirror circuit 321 and 322 may include current mirror circuits having a common gate structure, and the boosting circuit 400 may supply dynamic current to the common gates of these current mirror circuits. For example, the boosting circuit 400 may supply dynamic current to the common gate HPC of the first current mirror circuit 321 or to the common gate HNC of the second current mirror circuit 322.

The current mirror circuit 321 and 322 may include a reference current path through which a reference current flows and a mirroring current path through which a mirroring current flows, and the boosting circuit 400 may supply current. For example, the boosting circuit 400 can supply dynamic current to the common gate HPC of the first current mirror circuit 321, and this dynamic current can flow into the reference current path through the drain of the first reference current transistor MP4. As another example, the boosting circuit 400 can supply dynamic current to the common gate HNC of the second current mirror circuit 322, and this dynamic current can flow into the reference current path through the drain of the second reference current transistor MN4.

FIG. 5 is a diagram showing a slew boost circuit according to an embodiment of the present disclosure.

Referring to FIG. 5, the boosting circuit 400 includes a toggle circuit 410, a comparator 420, a first boosting current supply 430, a second boosting current supply 440, and a timing controller 450.

The comparator 420 may include a first comparison transistor TN2 and a second comparison transistor TP2 which have gates to which a first differential input voltage IP is applied and sources to which a second differential input voltage IM is applied.

The boosting circuit 400 may generate and supply dynamic current according to the current flowing through the first comparison transistor TN2 and the second comparison transistor TP2.

The first comparison transistor TN2 may be an N-type transistor. If the first differential input voltage IP and the second differential input voltage IM maintain similar voltage levels, no current may flow through the first comparison transistor TN2. Then, when the first differential input voltage IP rises (has a rising waveform), current may flow through the first comparison transistor TN2. The first comparison transistor TN2 may be connected to the first boosting current supply 430.

The first boosting current supply 430 mirrors the current flowing through the first comparison transistor TN2 through a first mirror circuit 431 and supplies the mirrored current to the common source CSP of the second differential amplifier circuit 312 and/or the common gate HNC of the second current mirror circuit 322.

In the first mirror circuit 431, the current flowing through the first comparison transistor TN2 flows to a P-type transistor TP3, and the current flowing through the P-type transistor TP3 can be mirrored to a P-type transistor TP4 and a P-type transistor TP5. The current flowing through the P-type transistor TP4 can be supplied to the common source CSP of the second differential amplifier circuit 312, and the current flowing through the P-type transistor TP5 can be supplied to the common gate HNC of the second current mirror circuit.

The second comparison transistor TP2 may be a P-type transistor. When the first differential input voltage IP and the second differential input voltage IM maintain similar voltage levels, no current may flow through the second comparison transistor TP2. Then, when the first differential input voltage IP drops (has a falling waveform), current may flow through the second comparison transistor TP2. The second comparison transistor TP2 may be connected to the first boosting current supply 430.

The first boosting current supply 430 can mirror the current flowing through the second comparison transistor TP2 through the second mirror circuit 432 and supply the mirrored current to the common source CSN of the first differential amplifier circuit 311 and/or the common gate HPC of the first current mirror circuit.

In the second mirror circuit 432, the current flowing through the second comparison transistor TP2 flows to an N-type transistor TN3, and the current flowing through the N-type transistor TN3 can be mirrored to another N-type transistor TN4 and one other N-type transistor TN5. Then, the current flowing through the N-type transistor TN4 is supplied to the common gate HPC of the first current mirror circuit, and the current flowing through the N-type transistor TN5 is supplied to the common source CSN of the first differential amplifier circuit.

The boosting circuit 400 may further include the second boosting current supply 440 and the timing controller 450.

The second boosting current supply 440 is connected in parallel with the first boosting current supply 430 and can supply current to the common source CSN of the first differential amplifier circuit or the common source CSP of the second differential amplifier circuit of the main source amplifier circuit 300 based on the operation of the timing controller 450.

The second boosting current supply 440 may include a first current source transistor TP6, which is a P-type transistor capable of generating current, and a second current source transistor TN6, which is an N-type transistor. The current generated from the first current source transistor TP6 is supplied to the common source CSP of the second differential amplifier circuit of the main source amplifier circuit 300, and the current generated from the second current source transistor TN6 is supplied to the common source CSN of the first differential amplifier circuit of the main source amplifier circuit 300.

The timing controller 450 may control the operating time of the second boosting current supply 440 by being synchronized with a timing of fluctuation in the first differential input voltage IP, and set the operating time according to each channel position of the display driver IC. Additionally, the timing controller 450 may supply current through the second boosting current supply only when necessary according to a rising/falling signal, thereby saving energy and improving signal quality.

The timing controller 450 controls switches included in the second boosting current supply according to each channel position of the display driver IC, and applies a bias to the gate nodes of the first current source transistor TP6 and the second current source transistor TN6 to supply current to the main source amplifier circuit 300 while adjusting the amount of current. This allows for a stable output waveform even at a low slew rate.

The boosting circuit 400 may further include the toggle circuit 410 in which an N-type transistor TN1 and a P-type transistor TP1 are connected in parallel, and the toggle circuit 410 may be disposed between the terminal to which the first differential input voltage IP is input and the gates of the comparison transistors TN2 and TP2. The boosting circuit 400 can control the voltage supplied to the gates of the toggle circuit 410 to turn off the toggle circuit 410 and prevent dynamic current from being supplied thereto.

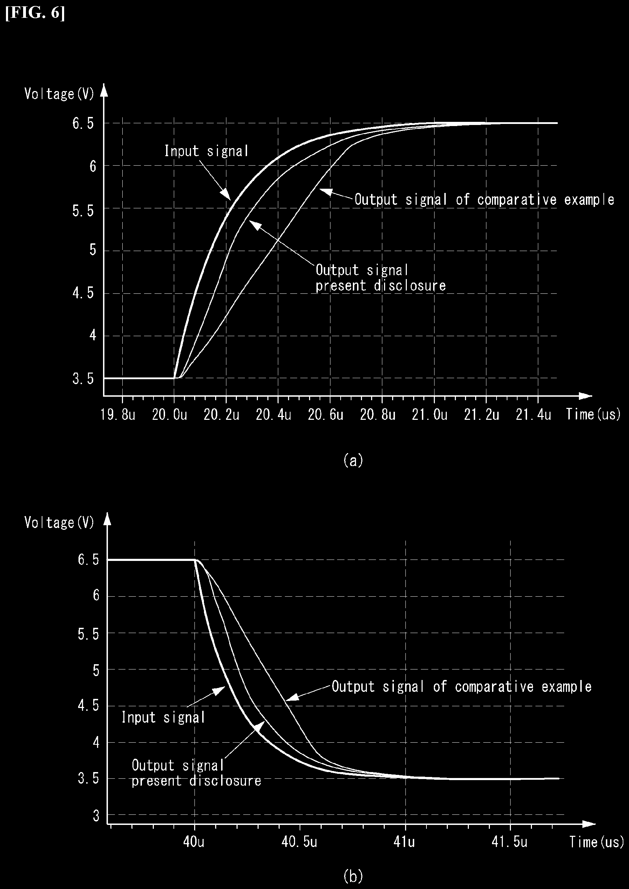

FIG. 6 is a diagram illustrating the effects of the slew boost circuit according to an embodiment of the present disclosure.

FIG. 6(a) shows the waveforms of an input signal and an output signal when an input voltage rises in an edge channel of a display driver IC. The x-axis represents time (µs), and the y-axis represents voltage (V). It can be seen that when the input voltage rises in the edge channel of the display driver IC, the output signal rises later than the input signal. Further, it can be seen that the output signal of the present disclosure is output closer to the input signal than the output signal of a comparative example. (Here, the comparative example refers to the case of a conventional slew boost circuit.) This demonstrates that the stability of the output waveform can be secured by the slew boost circuit according to the present disclosure even at a low slew rate in the edge channel of the display driver IC.

FIG. 6(b) is a voltage graph when the input voltage falls in the edge channel of the display driver IC. The x-axis represents time (µs), and the y-axis represents voltage (V). It can be seen that when the input voltage falls in the edge channel of the display driver IC, the output signal falls later than the input signal. It can be seen that the output signal of the present disclosure is closer to the input signal than the output signal of the comparative example. (Here, the comparative example refers to the case of a conventional slew boost circuit.) This demonstrates that the stability of the output waveform can be secured in the conventional slew boost circuit even at a low slew rate in the edge channel of the display driver IC.

It is obvious to those skilled in the art that the present disclosure can be embodied in other specific forms without departing from the spirit and essential features of the present disclosure. Accordingly, the above detailed description should not be interpreted restrictively in all respects but should be considered exemplary. The scope of the present disclosure should be determined by a reasonable interpretation of the appended claims, and all modifications within the equivalent scope of the present disclosure are included within the scope of the present disclosure.

The method according to the above-described embodiment may be produced as a program to be executed on a computer, and the program may be stored on a computer-readable recording medium. Examples of computer-readable recording media include a ROM, a RAM, a CD-ROM, a magnetic tape, a floppy disk, an optical data storage device, etc., and also include implementation in the form of a carrier wave (e.g., transmission over the Internet).

The computer-readable recording medium may be distributed across networked computer systems, and computer-readable code may be stored and executed in a distributed manner. Furthermore, functional programs, code, and code segments for implementing the above-described method can be easily inferred by programmers skilled in the art to which the embodiments belong.

It is obvious to those skilled in the art that the present disclosure may be embodied in other specific forms without departing from the spirit and essential features of the present disclosure.

Accordingly, the foregoing detailed description should not be interpreted restrictively in all respects and should be considered exemplary. The scope of the present disclosure should be determined by a reasonable interpretation of the appended claims, and all modifications within the equivalent scope of the present disclosure are included within the scope of the present disclosure.

## Claims

1. A slew boost circuit for supplying a current to a main source amplifier circuit, comprising:
a comparator configured to compare a first differential input voltage and a second differential input voltage and to generate a current;
a first boosting current supply configured to mirror the current flowing through the comparator and to supply the current to the main source amplifier circuit; and
a second boosting current supply configured to additionally supply a current to the main source amplifier circuit based on an operation of a timing controller.

2. The slew boost circuit according to claim 1, wherein the comparator comprises first and second comparison transistors having gates to which the first differential input voltage is applied and sources to which the second differential input voltage is applied, wherein when the first differential input voltage rises, a current flows through the first comparison transistor, and when the first differential input voltage falls, a current flows through the second comparison transistor.

3. The slew boost circuit according to claim 2, wherein the first boosting current supply comprises a mirror circuit configured to generate a mirroring current by mirroring current flowing through the first and second comparison transistors, and supplies the mirroring current to a common source and/or a common gate of the main source amplifier circuit.

4. The slew boost circuit according to claim 1, wherein the timing controller is synchronized with a timing of fluctuation in the first differential input voltage and sets a current supply time of the second boosting current supply differently for each channel position of the display driver IC.

5. The slew boost circuit according to claim 1, wherein the second boosting current supply comprises a first current source transistor and a second current source transistor, and when the first and second current source transistors are turned on, supplies a current to the common source of the main source amplifier circuit.

6. The slew boost circuit according to claim 1, wherein the second boosting current supply comprises first and second current source transistors, and the timing controller applies a bias to gate nodes of the first and second current source transistors to adjust an amount of current supplied to the common source of the main source amplifier circuit.

7. The slew boost circuit according to claim 4, wherein the current supply time is set within the range of 50 ns to 500 ns.

8. The slew boost circuit according to claim 2, wherein a toggle circuit in which an N-type transistor and a P-type transistor are connected in parallel is disposed between a terminal to which the first differential input voltage is input and gates of the first and second comparison transistors.

9. A method for controlling a slew boost circuit for supplying dynamic current to a main source amplifier circuit, the method comprising:
comparing a first differential input voltage and a second differential input voltage and generating a current;
mirroring the generated currentin response to the generated current and supplying the mirrored current to the main source amplifier circuit; and
additionally supplying a current to the main source amplifier circuit based on an operation of a timing controller.

10. The method according to claim 9, wherein the generating a current comprises allowing a current to flow to the first comparison transistor when the first differential input voltage rises, and allowing a current to flow to the second comparison transistor when the first differential input voltage falls.

11. The method according to claim 9, wherein the mirroring the generated current and supplying the current to the main source amplifier circuit comprises supplying the mirrored current to a common source and/or a common gate of the main source amplifier circuit.

12. The method according to claim 9, wherein the timing controller is synchronized at a timing of fluctuation in the first differential input voltage and sets a current supply time of the second boosting current supply differently for each channel position of a display driver IC.

13. The method according to claim 12, wherein the current supply time is set within the range of 50 ns to 500 ns.
